Europäisches Patentamt

European Patent Office

Office européen des brevets

(19)

(11) **EP 0 214 485 B1**

(12) **EUROPÄISCHE PATENTSCHRIFT**

(45) Veröffentlichungstag und Bekanntmachung des Hinweises auf die Patenterteilung:
**18.12.1996  Patentblatt 1996/51**

(51) Int Cl.6: **H01L 29/74**, H01L 29/10, H01L 29/36

(21) Anmeldenummer: **86111060.9**

(22) Anmeldetag: **11.08.1986**

(54) **Asymmetrischer Thyristor und Verfahren zu seiner Herstellung**

Asymmetric thyristor and method of making the same

Thyristor asymétrique et son procédé de fabrication

(84) Benannte Vertragsstaaten:
**DE FR GB SE**

(30) Priorität: **05.09.1985  DE 3531631**

(43) Veröffentlichungstag der Anmeldung:
**18.03.1987  Patentblatt 1987/12**

(73) Patentinhaber: **EUPEC**
**Europäische Gesellschaft für**
**Leistungshalbleiter mbH & Co. KG**
**D-59581 Warstein (DE)**

(72) Erfinder:
• **Borchert, Edgar, Dipl.-Phys**
**D-4788 Warstein 2 (DE)**
• **Schoof, Holger, Dr. Dipl.-Phys.**
**D-4784 Rüthen (DE)**
• **Sommer, Karl-Heinz, Dr. Dipl.-Phys.**
**D-4788 Warstein 2 (DE)**
• **Sonntag, Alois, Dipl.-Phys.**
**D-4788 Warstein 2 (DE)**

(74) Vertreter: **Fuchs, Franz-Josef, Dr.-Ing. et al**
**Postfach 22 13 17**
**80503 München (DE)**

(56) Entgegenhaltungen:
EP-A- 0 074 133          EP-A- 0 144 876
DE-A- 2 719 219          FR-A- 2 514 558
US-A- 4 356 503

• **S. M. Sze, Physics of Semiconductor Devices,**
**Second Edition (John Wiley & Sons, New York,**
**1981), Seiten 74 - 84**

EP 0 214 485 B1

## Beschreibung

Die Erfindung betrifft einen asymmetrischen Thyristor aus einem scheibenförmigen Halbleiterkörper mit mindestens vier Zonen abwechselnd entgegengesetzten Leitungstyps, bei dem die beiden äußeren Zonen hoch n- bzw. hoch p-dotiert sind und die n-leitende Basiszone aus einer an die innere Schicht angrenzenden schwach dotierten n⁻-Schicht und einer an die äußere p⁺-Schicht angrenzenden höher dotierten n-Schicht mit vom nn⁻-Übergang ansteigender Dotierungskonzentration besteht, sowie ein Verfahren zum Herstellen eines derartigen Thyristors.

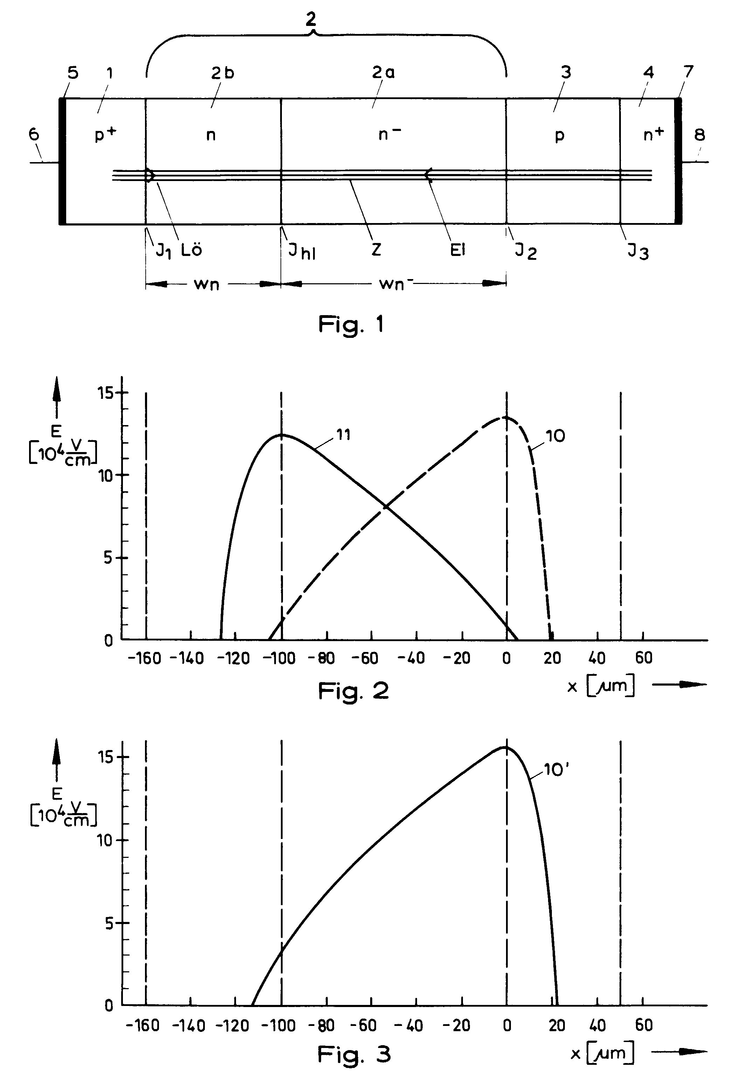

Asymmetrische Thyristoren dieser Art sind z. B. aus der EP-A-0 074 133, der US-A-4 356 503 und der FR-A-2 514 558 bekannt geworden. Ähnliche Thyristoren sind aus Proc. 29th IEEE Electronic Comp. Conf., New York, 1979, S. 75 bis 79 bekannt geworden. Das Sperrvermögen solcher asymmetrischer Thyristoren ist in Rückwärtsrichtung verglichen mit dem Sperrvermögen in Vorwärtsrichtung verhältnismäßig klein. In Figur 1 ist ein solcher bekannter asymmetrischer Thyristor im Prinzip dargestellt.

Der asymmetrische Thyristor besteht ebenso wie ein normaler Thyristor aus einer pnpn-Struktur, wobei die beiden außen liegenden Zonen 1 und 4 als Emitterzonen und die beiden inneren Zonen 2 und 3 als Basiszonen bezeichnet werden. An die p⁺-Emitterzone 1 schließt sich nach innen die n-Basiszone 2 an und an diese die p-leitende Steuerbasiszone 3, die nach außen an die n⁺-Emitterzone 4 angrenzt und - wie nicht weiter dargestellt - teilweise an die Oberflächenebene der n⁺-Emitterzone 4 geführt ist.

Zwischen der p⁺-Emitterzone 1 und der n-Basiszone 2 befindet sich ein pn-Übergang $J_1$, zwischen der n-Basiszone 2 und der p-Steuerbasiszone 3 ein pn-Übergang $J_2$ und zwischen der p-Steuerbasiszone 3 und der n⁺-Emitterzone 4 ein pn-Übergang $J_3$. Die p⁺-Emitterzone 1 ist auf eine Trägerplatte 5 auflegiert oder aufgelötet, die mit einem Anschluß 6 zur Stromzuführung versehen ist. Die n⁺-Emitterzone 4 ist auf ihrer Oberfläche mit einer metallischen Kontaktierungsschicht 7 und einem Anschluß 8 zur Stromzuführung versehen. Die p-Steuerbasiszone 3 hat auf ihrer freiliegenden Oberfläche - wie nicht weiter dargestellt - eine Kontaktierungsschicht und einen Steueranschluß. Die n-Basiszone 2 liegt auf fließendem Potential.

Zum Unterschied vom normalen Thyristor setzt sich beim asymmetrischen Thyristor die n-Basiszone 2 aus zwei Schichten zusammen, nämlich einer schwach n-dotierten n⁻-Schicht 2 a, die an die Steuerbasiszone 3 angrenzt, und einer höher n-dotierten n-Schicht 2 b, die an die p⁺-Emitterzone 1 angrenzt. Das Rückwärtssperrvermögen, das von dem pn-Übergang $J_1$ verursacht wird, ist infolge der verhältnismäßig hohen Dotierung der n-Basisschicht 2 b verhältnismäßig gering, beispielsweise etwa 100 V. Das Vorwärtssperrvermögen, das durch den pn-Übergang $J_2$ verursacht wird, ist infolge der geringen Dotierung und der verhältnismäßig großen Dicke der n⁻-Basisschicht 2 a dagegen hoch, beispielsweise etwa 1 300 V.

Es ist an sich wünschenswert, eine möglichst große höchstzulässige Vorwärtssperrspannung $U_{DRM}$ zu erhalten. Das bedeutet, daß die Fläche unter dem Feldstärkeprofil E(x) möglichst groß gemacht werden muß, wobei die maximale Feldstärke kleiner sein muß als die kritische Feldstärke $E_{krit}$, bei der der Lawinendurchbruch auftritt. Aus diesem Grunde weisen bekannte Anordnungen - wie beispielsweise IEEE TRANSACTIONS ON ELECTRON DEVICES, VOL. ED 23, NO. 8, AUGUST 1976, SEITE 823 bis 825, figur 1; GEC Journal of Science & Technology, Vol. 46, No. 2, 1980, DESIGN AND PERFORMANCE OF AN ASYMMETRICAL THYRISTOR, Figur 2 - in der Basiszone 2 in "kastenförmiges" Feldstärkeprofil auf.

Dabei verläuft die Feldstärke E(x) längs der n⁻-Zone 2 a annähernd waagerecht oder schwach geneigt. In der n-Zone 2 b fällt E(x) jedoch am nn⁻-Übergang $J_{h1}$ verhältnismäßig steil auf nahezu Null b, so daß die Raumladungszone nur wenig in die n-Zone 2 b eindringt, was sich vorteilhaft auf das Vorwärtssperrvermögen auswirkt. Der beschriebene Feldverlauf wird durch eine niedrige Dotierungskonzentration in der n⁻-Zone 2a und einem verhältnismäßig steilen Anstieg der Dotierungskonzentration von der n⁻-Zone 2a zur n-Zone 2b erreicht.

Bei solchen bekannten asymmetrischen Thyristoren tritt nun das Problem auf, daß sie bei Kommutierung aus der Durchlaßphase in die Sperrphase und anschließendem Wiederanlegen der positiven Spannung noch innerhalb der Freiwerdezeit bei höherer Spannungsanstiegsgeschwindigkeit du/dt in ihrer Funktionsfähigkeit beeinträchtigt werden. Ihre Sperrspannung $U_{RRM}$ nimmt nämlich nach jeder Kommutierung immer weiter ab und schließlich können sie sogar völlig zerstört werden, was für die praktische Anwendung solcher Thyristoren äußerst nachteilig ist.

Aufgabe der Erfindung ist es einen asymmetrischen Thyristor und ein Verfahren zu seiner Herstellung anzugeben, dessen Freiwerdezeit ohne Funktionsbeeinträchtigung oder gar Zerstörung unterschritten werden kann und der daher beim Wiederzünden durch positive Spannung nach einer Kommutierung nicht die oben genannten Nachteile der geringer werdenden Sperrspannung zeigt.

Diese Aufgabe wird bei einem asymmetrischen Thyristor der erwähnten Gattung dadurch gelöst, daß die Dicke und die Dotierungskonzentration der n⁻-Schicht so bemessen sind, daß der Maximalwert der Feldstärke $E_2$ bei der höchsten Vorwärtsspannung am pn⁻-Übergang $1,5 \times 10^5$ V/cm beträgt, daß die Feldstärke in der n⁻-Schicht linear abnimmt und am nn⁻-Übergang einen Wert von $0,1 E_2$ bis $0,4 E_2$ hat, und daß die Dotierungskonzentration in der n-Schicht vom nn⁻-Übergang in Richtung zum anodenseitigen pn⁻-Übergang auf einer Strecke von mindestens 50 μm auf ihren

Maximalwert ansteigt.

Vorzugsweise liegt der Wert $E_{h1}$ zwischen 0,2 $E_2$ und 0,3 $E_2$.

Die Erfindung geht von der überraschenden Erkenntnis aus, daß die Beeinträchtigung und gegebenenfalls Zerstörung des Thyristors beim Wiederzünden nach vorausgegangener Kommutierung durch lokale Feldstärkenüberhöhungen an dem zwischen der n-Schicht 2b und der $n^-$-Schicht 2a liegenden $nn^-$-Übergang $J_{h1}$ eingeleitet wird, wie nachstehend näher ausgeführt wird.

Es wird hierbei angenommen, daß lokale Feldstärkenmaxima, die am $nn^-$-Übergang auftreten, die Ursache für die Degradationen und Zerstörunen sind, die nach Zünden durch Anlegen von Vorwärtspannung vor Ablauf der Freiwerdezeit auftreten. Im Zündkanal Z, der durch lokale Durchlaßpolung des pn-Übergangs $J_3$ entsteht (siehe Figur 1), kann die Konzentration der über diesen pn-Übergang injizierten Elektronen so hoch werden, daß die Donatorkonzentration in der $n^-$-Schicht 2a überkompensiert wird und damit die resultierende Raumladung negativ wird. Dann hat die elektrische Feldstärke im Zündkanal Z einen Verlauf, der vom $pn^-$-Übergang $J_2$ zum $nn^-$-Übergang $J_{h1}$ ansteigt und dort sein Maximum erreicht, wie in Figur 2 durch die Kurve 11 dargestellt ist.

Die Konzentration der Stromlinien im Zündkanal Z und die hohe elektrische Feldstärke am $nn^-$-Übergang $J_{h1}$ führen zur Konzentration der elektrischen Verlustleistung und zur thermischen Überlastung eines räumlich eng begrenzten Gebietes. Die damit verbundene thermische Erzeugung von Ladungsträgerpaaren bewirkt bei genügend hoher Temperatur das thermische Weglaufen (thermal run-away), das zur Bildung von lokalen Schmelzstellen oder sogar von Schmelzkanälen führt, wodurch das Bauelement lokal beschädigt und damit in seiner Funktion beeinträchtigt oder zerstört wird. Wenn das Feldstärkemaximum im Zündkanal Z oberhalb von $1,5 \cdot 10^5$ V/cm liegt, können durch Stoßionisation so viele Ladungsträgerpaare erzeugt werden, daß die dadurch erhöhte Stromdichte das thermische Weglaufen einleitet.

Bei asymmetrischen Thyristoren mit verhältnismäßig steilem $nn^-$-Übergang $J_{h1}$ wurde gefunden, daß die Zerstörung bevorzugt im Gebiet zwischen dem $nn^-$-Übergang $J_{h1}$ und dem pn-Übergang $J_1$ ansetzt. Zur Erklärung wird angenommen, daß sich das Maximum der elektrischen Feldstärke im Zündkanal vom $nn^-$-Übergang $J_{h1}$ in die n-Schicht 2b verschiebt, sobald eine starke Erzeugung von Ladungsträgern einsetzt. Als Grund hierfür wird angesehen, daß die beim $nn^-$-Übergang $J_{h1}$ erzeugten, zur p-Steuerbasiszone 3 fließenden Löcher die negative Raumladung verringern, während die bei dem $nn^-$-Übergang $J_{h1}$ erzeugten, in die n-Schicht 2b fließenden Elektronen die negative Raumladung verstärken. Daher wird der Schnittpunkt zwischen dem in Richtung zum pn-Übergang $J_1$ ansteigenden Donatorprofil und der Elektronenkonzentration in

die n-Schicht 2b hinein verschoben; dieser Schnittpunkt gibt jedoch die Lage des Feldstärkemaximums an.

Die Erfindung wird nachstehend anhand der dargestellten Figuren näher erläutert. Es zeigen hierbei

| | |
|---|---|
| Figur 1 | eine Zonenfolge eines asymmetrischen Thyristors, |
| Figur 2 | den Verlauf der elektrischen Feldstärke in der $n^-$-Schicht bei einem asymmetrischen Thyristor gemäß der Erfindung mit einer Vorwärtssperrspannung von 1000 V, |
| Figur 3 | den Verlauf der elektrischen Feldstärke in der $n^-$-Schicht bei einem asymmetrischen Thyristor gemäß der Erfindung mit einer Vorwärtssperrspannung von 1 300 V, |
| Figur 4 | Dotierungsprofile der n-Schicht und der p-Steuerbasiszone bei einem den Feldverlauf nach Figur 3 aufweisenden asymmetrischen Thyristor, |
| Figur 5 | den resultierenden Dotierungsverlauf für einen den Feldverlauf nach Figur 3 und die Dotierungsprofile nach Figur 4 aufweisenden asymmetrischen Thyristor, |
| Figur 5 | Verfahrensschritte zum Herstellen eines nach den Figuren 2 bis 5 ausgebildeten asymmetrischen Thyristors, wobei die n-leitende Schicht 2 mittels Epitaxie erzeugt wird, |
| Figur 7 | Verfahrensschritte zum Herstellen eines nach den Figuren 2 bis 5 ausgebildeten asymmetrischen Thyristors, wobei die n-leitende Schicht 2b mittels Ionenimplantation von Phosphoratomen erzeugt wird, |
| Figur 8 | Verfahrensschritte zum Herstellen eines nach den Figuren 2 bis 5 ausgebildeten asymmetrischen Thyristors, wobei die n-leitende Schicht 2b durch Phosphorbelegung mittels planarer Feststoffquellen erzeugt wird, |
| Figur 9 | einen weiteren Dotierungsverlauf und die Dikkenabmessung der Zonen eines asymmetrischen Thyristors nach der Erfindung. |

Wie vorstehend dargelegt wurde, beginnt eine kritische Phase beim Betrieb eines asymmetrischen Thyristors dann, wenn nach Durchlaßbelastung und anschließender Kommutierung die Spannung am Bauelement schnell ansteigt, bevor dessen Freiwerdezeit abgelaufen ist. Es kommt dann nur Zündung des asymmetrischen Thyristors, weil die p-Steuerbasiszone 3 von der vorausgegangenen Durchlaßbelastung her noch gespeicherte Ladungsträger enthält. Dabei wirken die während des Spannungsanstiegs aus der p-Steuerbasiszone 3 unter der n-Emitterzone 4 parallel zum pn-Übergang $J_3$ zu den Emitter-Basis-Kurzschlüssen abfließenden Löcher als Steuerstrom. Dieser Steuerstrom ist um so höher, je größer die noch gespeicherte Ladungsträgermenge ist.

Die Zündung erfolgt meistens lokal an Schwachstellen, beispielsweise in Bereichen, wo Emitter-Basis-Kurzschlüsse fehlen oder infolge technologischer Fehler mangelhaft sind. An einer solchen Schwachstelle wird der pn-Übergang $J_3$ lokal in die Durchlaßrichtung gesteuert, so daß er Elektronen in die p-Steuerbasiszone 3 injiziert (siehe Figur 1). Die injizierten Elektronen fließen durch die p-Steuerbasiszone 3 und durch die n⁻-Schicht 2 a in Richtung zur p⁺-Emitterzone 1. Dabei wird die Raumladungszone des pn-Übergangs $J_2$ durchlaufen. Wegen der lokalen Injektion fließen die Elektronen El in einem engen Zündkanal Z von beispeilsweise 100 µm Durchmesser, und während einer Zeitspanne in der Größenordnung von Mikrosekunden wird der Strom im Zündkanal Z im wesentlichen von Elektronen geführt, während über den pn-Übergang $J_1$ injizierte Löcher Lö noch kaum zum Strom beitragen. In dieser Zeitspanne vorherrschenden Elektronenstroms ist der durch das Bauelement fließende Strom noch verhältnismäßig gering, nämlich in der Größenordnung von 1 A, dagegen kann die Stromdichte im Zündkanal Z hohe Werte in der Größenordnung von 100 A/cm² annehmen. Die Spannung am Bauelement während der betrachteten Zeitspanne kann nahe an dem durch die Schaltung vorgegebenen Höchstwert der Vorwärtssperrspannung liegen, sofern die Spannungsanstiegsgeschwindigkeit einen anwendungsüblichen hohen Wert in der Größenordnung von 100 V/µs aufweist.

Im Zündkanal Z erreichen die Elektronen ihre Grenzgeschwindigkeit $v_1 \sim 10^7$ cm/s; daher wird die Elektronenstromdichte $j_n$ der Elektronenkonzentration n proportional. Bei genügend hoher Elektronenstromdichte $j_n$, das heißt bei genügend starker lokaler Durchlaßpolung des pn-Überganges $J_3$, wird die Elektronenkonzentration n größer als die Dotierung $N_{DG}$ der n⁻-Schicht 2 a. Daher wechselt die Raumladung der n⁻-Schicht 2 a im Zündkanal Z ihr Vorzeichen, und damit wechselt auch die Divergenz das elektrischen Feldes ihr Vorzeichen. Das bedeutet, daß sich das Maximum des elektrischen Feldes vom pn-Übergang $J_2$ zum nn⁻-Übergang $J_{h1}$ verlagert hat, wie in der Figur 2 durch die Kurven 10 und 11 angedeutet ist.

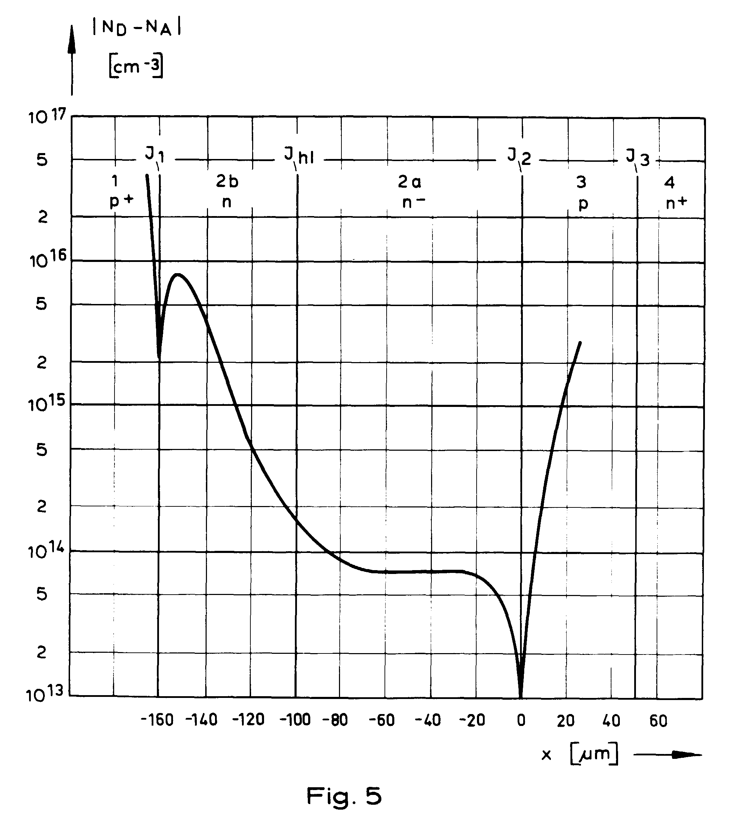

Die Kurve 10 stellt den Verlauf der elektrischen Feldstärke E(x) außerhalb des Zündkanals für die im betrachteten Zeitpunkt anliegende Vorwärtssperrspannung $u_D$ dar. Die Kurve 10 stimmt praktisch mit dem stationären Verlauf der elektrischen Feldstärke E(x) für das gleiche $u_D$ überein. Es ist ein in Figur 5 dargestellter Dotierungsverlauf eines asymmetrischen Thyristors zugrunde gelegt.

Die Kurve 11 stellt den Verlauf der elektrischen Feldstärke E(x) längs der Zündkanals für denselben Augenblickswert von $u_D$ wie bei der Kurve 10 dar. Der vom Zündkanal durchsetzte Teil der n⁻-Schicht 2 a ist durch die verhältnismäßig hohe Elektronenkonzentration sozusagen umdotiert worden. Es ist angenommen, daß die Felddivergenz durch diese Umdotierung so weit ins Negative geht, daß die elektrische Feldstärke am pn-

Übergang $J_2$ nur noch etwa $10^4$ V/cm beträgt. Eine solche Feldstärke reicht dafür aus, daß die Elektronen mit ihrer Grenzgeschwindigkeit $v_1$ fließen. Der Anstieg der Kurve 11 nach links endet am nn⁻-Übergang $J_{h1}$; denn die in der n-Schicht 2 b nach links ansteigende Donatorkonzentration übersteigt bald die Elektronenkonzentration im Zündkanal. Daher existiert in der n-Schicht 2 b eine positive Raumladung im Zündkanal, die im wesentlichen durch die Donatorkonzentration bestimmt ist. Daher fällt die elektrische Feldstärke E(x) links vom nn⁻-Übergang $J_{h1}$ ab.

Wegen des flachen Dotierungsgradienten in der n-Schicht 2 b liegt der linke Fußpunkt der E(x)-Kurven weitab vom nn⁻-Übergang $J_{h1}$ in der n-Schicht 2 b. Der durch die Kurve 11 wiedergegebene E(x)-Verlauf ähnelt dem eines flachen np⁻-Übergangs. Die Fläche unter der Kurve 11 ist ebenso wie die Fläche unter der Kurve 10 gleich der hier angenommenen Vorwärtssperrspannung $u_D = 1000$ V. Der flache nn⁻-Übergang $J_{h1}$ bewirkt nach Figur 2, Kurve 11, ein breites, aber verhältnismäßig niedriges Maximum der elektrischen Feldstärke E(x) im Zündkanal Z. Dadurch werden thermische Überlastungen und Stoßionisation im Zündkanal Z verhindert.

In der Figur 3 zeigt die Kurve 10' den Verlauf der elektrischen Feldstärke E(x) in der n⁻-Schicht 2 a eines für 1 300 V Vorwärtssperrspannung ausgelegten asymmetrischen Thyristors. Die Dotierung $N_{DG}$ der n⁻-Schicht 2 a beträgt $8 \cdot 10^{13}$ Donatoren/cm³, entsprechend einem spezifischen Widerstand von 60Ωcm. Die dicke $w_n$ - der n⁻-Schicht 2 a beträgt 100 µm. Die Dotierung $N_{DG}$ und die Dicke $w_n$- der n⁻-Schicht 2 a sind so gewählt, daß bei der höchsten für das Bauelement vorgesehenen Vorwärtssperrspannung $u_{Dmax}$ der Maximalwert $E_2$ der Feldstärke am pn-Übergang $J_2$ etwa 1,5 $\cdot 10^5$ V/cm beträgt und der Wert $E_{h1}$ der Feldstärke am nn⁻-Übergang $J_{h1}$ bei etwa $E_2/4$ liegt. Durch die Vorgabe der Vorwärtssperrspannung $u_{Dmax}$ sowie der Feldstärkewerte $E_2$ und $E_{h1}$ sind die Dicke $w_n$- und die Dotierungskonzentration $N_{DG}$ der n⁻-Schicht 2 a eindeutig bestimmt, sofern der Verlauf der beiden Dotierungsprofile bekannt ist, die bei der Herstellung der Steuerbasiszone 3 und der n-Schicht 2 b (Stoppschicht) erzeugt werden und die den Verlauf des elektrischen Feldes am pn-Übergang $J_2$ und am nn⁻-Übergang $J_{h1}$ beeinflussen.

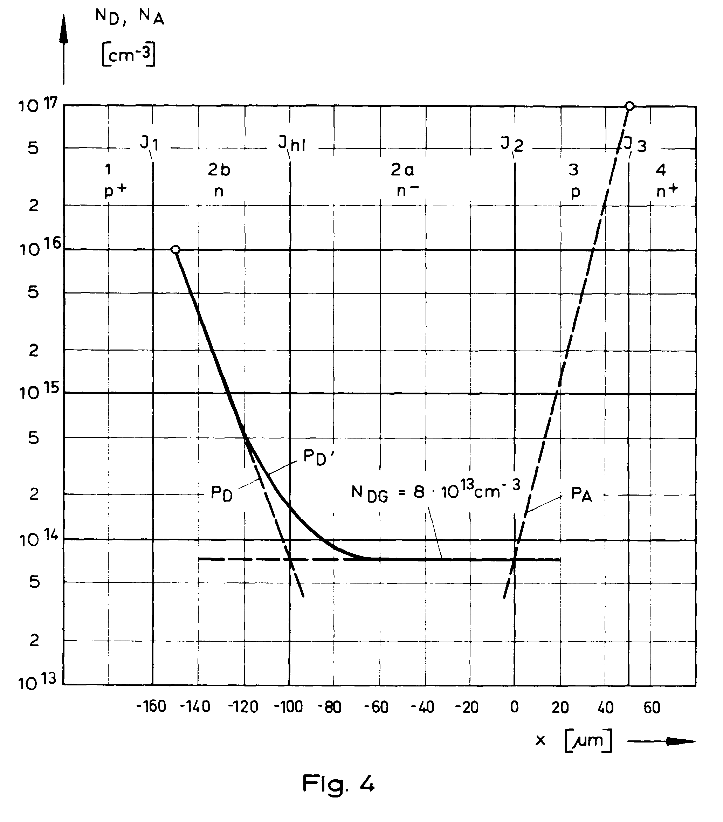

Figur 4 zeigt diese Dotierungsprofile, die der E(x)-Kurve der Figur 3 zugrunde gelegt sind. Das Donatorprofil setzt sich aus der Donator-Grunddotierung $N_{DG}$ und einem diese überlagernden exponentiellen Profil $P_D$ zusammen, das am nn⁻-Übergang $J_{h1}$ denselben Wert wie eine Donator-Grunddotierung hat und in Richtung zum pn-Übergang $J_1$ längs einer 50 µm langen Strecke auf $10^{16}$ cm⁻³ ansteigt. Das resultierende Donatorprofil $P'_D$ ergibt keine scharfe Grenze zwischen der n⁻-Schicht 2 a und der n-Schicht 2 b, doch ist die Stelle des Übergangs $J_{h1}$ durch die Bedingung, daß die resultierende Donatorkonzentration gleich $2 N_{DG}$ ist, eindeutig festgelegt. Das zugehörige exponentielle Akzeptorprofil $P_A$ steigt vom Wert $N_{DG}$ am pn-Übergang $J_2$ ins Innere der p-Schicht 3 längs einer Strecke von 50 μm Länge auf $10^{17}$ cm$^{-3}$. Ein flaches Donatorprofil $P_D$ - wie in Figur 4 gezeigt - und eine geringe Dotierung $N_{DG}$ und Dicke $w_n$- der n$^-$-Schicht 2a führen dazu, daß die Raumladungszone bei Anliegen von Vorwärtssperrspannung tief in die n-Schicht 2 b eindringt. Das kann anschaulich folgendermaßen verstanden werden. Die in der n$^-$-Schicht 2 a vorhandenen Donatoren reichen nicht aus, um eine positive Raumladung der Stärke zu liefern, die zum Aufbau des der gegebenen Spannung entsprechenden Feldes erforderlich ist. Die fehlende positive Raumladung wird dadurch beschafft, daß sich die Raumladungszone in die n-Schicht 2 b ausdehnt. Wegen des langsamen Anstiegs der Donatorkonzentration durch den flachen Dotierungsgradienten wird ein breites an den nn$^-$-Übergang $J_{h1}$ angrenzendes Gebiet in die Raumladungszone einbezogen.

Ein tiefes Eindringen der Raumladungszone in die n-Schicht 2 b bei Anliegen statischer Vorwärtssperrspannung ist jedoch unerwünscht, weil dadurch der Stromverstärkungsfaktor $\alpha_{p+np}$ des aus der p$^+$-Emitterzone 1, den Schichten 2 a und 2 b der Basiszone 2 und der p-Steuerbasiszone 3 bestehenden Teiltransistors erhöht wird, was zur Verschlechterung der Vorwärtssperreigenschaften führt. Die oben beschriebene Festlegung der Dotierung $N_{DG}$ und der Dicke $w_n$- der n$^-$-Schicht 2 a durch Vorgabe der maximalen statischen Vorwärtssperrspannung $u_{Dmax}$ sowie der Feldstärkewerte $E_2$ und $E_{h1}$ gewährleistet jedoch, daß trotz des flachen Donatorprofils $P_D$ nach Figur 4 die Raumladungszone nur wenig in die n-Schicht 2 b eindringt. Dies zeigt der durch die Kurve 10' wiedergegebenen Feldstärkeverlauf in der Figur 3. Dort beträgt die Eindringtiefe der Raumladungszone in die n-Schicht 2 b, die durch den linken Fußpunkt der Kurve 10' gekennzeichnet ist, nur etwa 10 μm.

Die in Figur 4 dargestellten Donator- und Akzeptorprofile für $N_{DG} = 8 \cdot 10^{13}$ cm$^{-3}$ ergeben eine Netto-Dotierung $|N_D - N_A|$, die in Figur 5 dargestellt ist. $N_D$ bedeutet die Donatorkonzentration, $N_A$ die Akzeptorkonzentration. Dabei sind in der n-Schicht 2 b die Ausläufer der Akzeptorprofils der p$^+$-Emitterzone 1 mit berücksichtigt. In der Schicht 2 b entsteht aus dem annähernd exponentiellen Donatorprofil der Figur 4 (für $N_{DG} = 8 \cdot 10^{13}$ cm$^{-3}$) und dem kompensierenden Ausläufer des Akzeptorprofils der p-Emitterzone 1 ein Nettodotierungsprofil, das beispielsweise ein Maximum von $7 \cdot 10^{15}$ cm$^{-3}$ in einem Abstand von 53 μm vom nn$^-$-Übergang $J_{h1}$ erreicht und in einem Abstand von 60 μm vom nn$^-$-Übergang $J_{h1}$ steil zum pn-Übergang $J_2$ abfällt.

Dieses Beispiel eines Netto-Dotierungsprofils erzeugt einen erwünschten flachen nn$^-$-Übergang $J_{h1}$; denn die Netto-Dotierungskonzentration in der n-Schicht 2 b steigt von der Grenze zur n$^-$-Schicht 2 a in Richtung zum anodenseitigen pn-Übergang $J_1$ längs einer Strecke von mindestens 50 μm im wesentlichen exponentiell auf ihren Maximalwert an. Dabei liegt der Maximalwert nach einer bekannten Dimensionierungsvorschrift bei $2 \cdot 10^{15}$ bis $4 \cdot 10^{16}$ cm$^{-3}$. Netto-Dotierungsprofile, die flache nn$^-$-Übergänge $J_{h1}$ erzeugen, können durch Diffusionsprozesse erzielt werden, gegebenenfalls auch in Kombination mit Epitaxie und Ionenimplantation.

Es hat sich gezeigt, daß bei der praktischen Dimensionierung eines asymmetrischen Thyristors der angegebene Maximalwert $E_2$ der Feldstärke von etwa $1,5 \cdot 10^5$ V/cm nicht wesentlich überschritten werden kann. Bei diesem Wert ist die Ladungsträgermultiplikation noch so gering, daß kein unerwünscht hoher Vorwärtssperrstrom bei maximaler Sperrschichttemperatur fließt. Größere Werte als der Maximalwert $E_2$ führen wegen der schnell zunehmenden Ladungsträgermultiplikation in Verbindung mit der Stromabhängigkeit des Stromverstärkungsfaktors $\alpha_{p+np}$ des aus der p$^+$-Emitterzone 1, den Schichten 2 a und 2 b der n-Basiszone und der p-Steuerbasiszone 3 bestehenden Teiltransistors zu einem unzulässig hohen Vorwärtssperrstrom.

An einigen Beispielen soll die Herstellung eines asymmetrischen Thyristors nach der Erfindung nachstehend ausführlich beschrieben werden.

Beispiel 1:

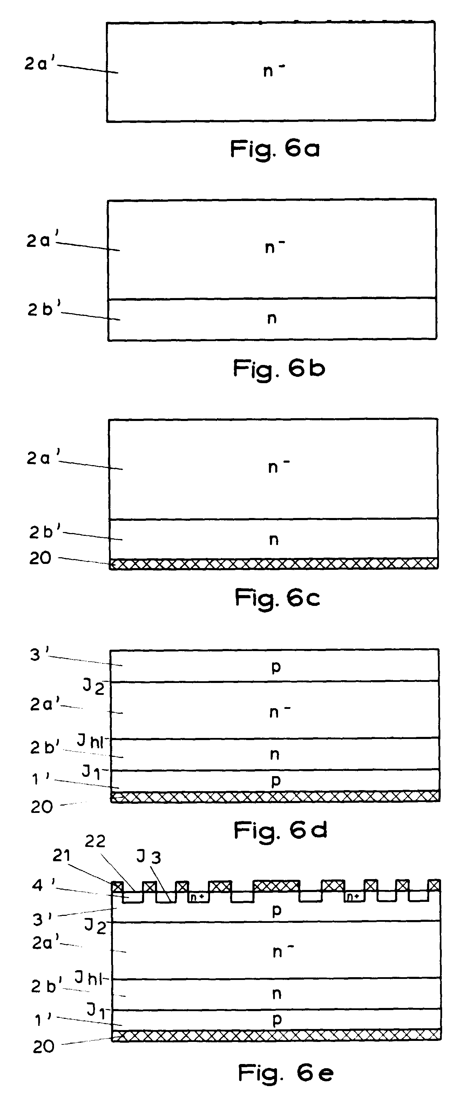

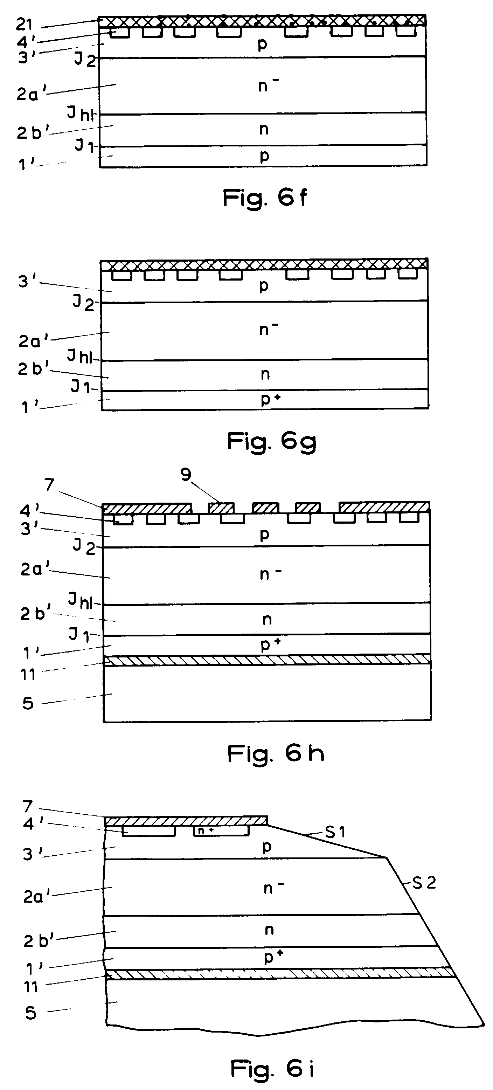

Herstellung eines asymmetrischen Thyristors (ASCR) mit einer n$^+$pn$^-$np$^+$-Zonenfolge, wobei die n-leitende Schicht 2 b' durch Epitaxie erzeugt wird (siehe Figur 6).

Als Ausgangsmaterial werden zonengezogene, durch eine Phosphordotierung schwach n-leitende Siliziumkristalle von beispielsweise 60 mm Durchmesser benutzt, bei denen die Phosphordotierung durch eine Neutronenbestrahlung erzeugt wird. Die Höhe der Phosphordotierung wird entsprechend dem gewünschten Sperrvermögen des Bauelementes bemessen. Bei dem hier ausgeführten Beispiel eines asymmetrischen Thyristors mit einer maximalen Blockierspannung $u_{DRM}$ = 2 000 V wird der spezifische Widerstand des Ausgangskristalls zu $\rho = 110$ Ωcm ± 20 % gewählt.

Mit den bekannten Verfahren der Siliziumbearbeitung, Sägen, Läppen und einseitigem Polieren wird der Ausgangskristall zu Substratscheiben 2 a' von 280 μm Stärke verarbeitet (siehe Figur 6 a). Auf die polierte Seite dieser schwach n-leitenden Substrate wird ein Epitaxieschicht 2 b' von 45 bis 55 μm Stärke abgeschieden, wobei eine Phosphordotierung von etwa $1,3 \cdot 10^{17}$ Atomen/cm$^3$ eingebracht wird, was einem spezifischen Widerstand von $\rho = 0,075$ Ωcm ± 10 % entspricht (siehe Figure 6 b).

Durch einen ersten Oxidationsschritt - beispielsweise 7 h in strömenden feuchten Sauerstoff und nachfolgendem einseitigen Abätzen der Oxidschicht auf der Oberfläche der n$^-$-Zone 2 a' - erhält man die einseitig oxidierte Siliziumscheibe gemäß Figur 6 c. Nach diesem Arbeitsschritt ist die vergleichsweise hoch phosphordotierte Zone 2 b' durch eine Oxidschicht 20 gegen Phosphorverluste durch Ausdiffusion in weiteren Hochtemperturschritten gesichert. Es wird gleichzeitig verhindert, daß sich eine unerwünschte Phosphordotierung auf der nicht mit einer Oxidschicht maskierten Oberfläche der n⁻-Zone 2 a'niederschlägt. Die Stärke der Oxidschicht 20 beträgt 1 bis 2 $\mu$m und ist für den Prozeßablauf unkritisch.

In einem nächsten Arbeitsschritt werden die einseitig oxidierten Siliziumscheiben mittels einer Ampullendiffusion in bekannter Technik (Stapelung der Siliziumscheiben mit Quarzspacern in einem einseitig verschlossen Quarzrohr, Zugabe von Galliumquellen in Form von Siliziumwürfeln mit etwa 20 mg einlegiertem Gallium, Verschließen mit einer Schutzgasfüllung aus Argon bei einem Druck von etwa 230 mbar) mit einer Galliumdotierung versehen. Diese Galliumdiffusion wird während einer Dauer von 35 h bei einer Temperatur von 1 255 °C durchgeführt. Sie bewirkt - wie in die Figur 6 d dargestellt ist - drei Veränderungen in der Zonenfolge der Siliziumscheibe. Auf der nicht maskierten Seite der Siliziumscheibe, der späteren Kathodenseite des Thyristors, bildet sich die p-leitende Zone 3' mit einer Eindringtiefe von 60 $\mu$m, einer Galliumoberflächenkonzentration von $1 \cdot 10^{18}$ bis $6 \cdot 10^{18}$ Atomen/cm$^3$ und einem Schichtwiderstand von etwa $R_s = 20$ $\Omega/\square$, gemessen an der Oberfläche, aus. Da Siliziumoxid keine maskierende Wirkung für den Dotierstoff Gallium besitzt, bildet sich gleichzeitig auf der späteren Anodenseite des Thyristors durch Umdotierung eines Teils der n-leitenden Zone 2 b' ebenfalls eine p-leitende Zone 1' aus, die mit der n-leitenden Zone 2 b' den pn-Übergang $J_1$ entstehen läßt. Dieser pn-Übergang $J_1$ liegt nach dem Galliumdiffusionsprozeß in einer Tiefe von etwa 25 bis 30 $\mu$m. Der Schichtwiderstand der n-leitenden Basiszone 2 b' sollte nach diesem Dotierungsprozeß zwischen 70 und 100 $\Omega/\square$ liegen. Eine Kontrollmessung dieses Parameters kann durch schrittweises Abtragen von Silizium und 4-Punkt-Sondenmessungen an einer herauspräparierten Testscheibe erfolgen. Die n-leitende Zone 2 b' verliert durch Ausdiffusion in die schwach dotierte n⁻-Zone 2 a' ihren steilen Konzentrationsgradienten am nn⁻-Übergang $J_{h1}$, den sie auf Grund der epitaktischen Herstellung besaß. Der nn⁻-Übergang $J_{h1}$ liegt nach diesem Prozeßschritt in einer Tiefe von etwa 80 $\mu$m, gemessen von der Oberfläche der anodenseitigen p-leitenden Zone 1'.

Die Siliziumscheibe mit der Zonenfolge gemäß Figur 6 d wird durch einen zweiten Oxidationsschritt - beispielsweise während einer Dauer von 7 h bei 1 150 °C in feuchtem strömenden Sauerstoff - auch auf der Oberfläche der p-leitenden Zone 3' mit einer Oxidschicht 21 versehen.

In diese Oxidschicht 21 werden mittels bekannter photolithographischer Verfahren Fenster 22 eingeätzt, durch die in einem weiteren Hochtemperaturschritt - beispielsweise mittels einer typischen Phosphordiffusion während einer Dauer von 4 bis 8 h bei 1 260 °C und einer Oberflächenkonzentration von etwa $5 \cdot 10^{21}$ Phos-

phoratomen/cm$^3$ die n⁺-Emitterschicht 4' erzeugt wird. Die resultierende Zonenfolge ist in Figur 6 e schematisch dargestellt. Bezüglich der geometrischen Gestaltung der Fenster 22 gelten die in der Thyristortechnologie bekannten Dimensionierungsüberlegungen; so wird man beispielsweie zur Realisierung niedriger Einschaltverluste ein Amplifying Gate mit verzweigtem Hauptemitter wählen und zur Erzielung hoher kritischer Spannungssteilheiten du/dt$_{krit}$ Emitterkurzschlüsse vorsehen.

Durch einen dritten Oxidationsschritt - beispielsweise während einer Dauer von 2 h bei 1 150 °C in strömendem feuchten Sauerstoff werden die Fenster 22 mit einer Siliziumoxidschicht wider geschlossen und anschließend die anodenseitige Oxidschicht 20 vollständig entfernt (siehe Figur 6 f). Durch eine 1 bis 3 h dauerende Bordiffusion bei 1 255 °C wird danach die Akzeptorkonzentration in der p⁺-Emitterschicht 1' auf $N_s =$ etwa $10^{20}$ Atome/cm$^3$ angehoben. Es ergibt sich damit die in Figur 6 dargestellte Zonenfolge.

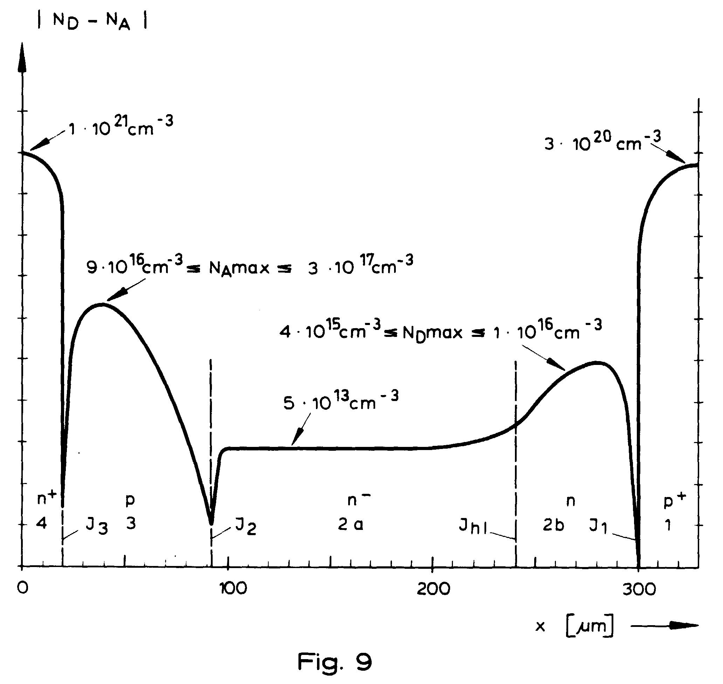

Die angeführten Zeiten und Temperaturen der Phosphordiffusion zur Erzeugung der n⁺-Emitterschicht 4' und der Bordiffusion zur Erzeugung der p⁺-Emitterschicht 1' sind lediglich beispielhafte Werte, mit denen man den Herstellungsprozeß erfolgreich durchführen kann. Als Dotierstoffquellen für die Phosphordiffusion können beispielsweise POCl$_3$ oder PBr$_3$ und für die Bordiffusion beispielsweise Bornitrid-Scheiben oder BBr$_3$ eingesetzt werden, also Standardmethoden zur Dotierung von n⁺-leitenden bzw. p⁺-leitenden Zonen. In dem hier angeführten Beispiel wird die Zeitdauer im Einzelfall so gewählt, daß nach Abschluß des letzten Hochtemperaturschrittes, der Bordiffusion, das in Figur 9 aufgezeichnete Störstellenprofil vorliegt.

Nach der vollständigen Entfernung der kathodenseitigen Oxidschicht 21 wird in bekannter Weise die Lebensdauer der injizierten Ladungsträger in den Zonen 2 a' und 2 b' durch Eindiffusion von beispielsweise Goldatomen, die im Siliziumkristall als Rekombinationszentren wirken, erniedrigt. Die Aufbringung der Goldatome kann sowohl durch Bedampfung der Siliziumscheiben im Hochvakuum als auch durch chemische Abscheidung aus einer sauren Goldsalzlösung erfolgen. Die typische Temperatur zur Eintemperatur des Goldes leigt im hier beschriebenen Beispiel bei etwa 830 bis 840 °C. Die Zeitdauer beträgt 1 h.

Hieran anschließend wird in bekannter Weise die Siliziumscheibe des Thyristors mit Metallkontakten 9 und 7 für die Gate- und Kathodenanschlüsse versehen und durch einen Legierungsprozeß mittels einer Siluminschicht 11 von etwa 30 $\mu$m Stärke mit einer Molybdänscheibe5verbunden, wie in Figur 6 h dargestellt ist.

Die Bearbeitung des Randes der Siliziumscheibe zur Entfernung von Kurzschlüssen und gestörten Kristallbereichen, etwa durch Sandstrahlen, Schleifen mit Siliziumkarbid in einer Halbschale oder Abtragung mit einem Diamantwerkzeug, wird so ausgeführt, daß in Flach- und Steilschliff - wie in Figur 6 i dargestellt ist - entsteht. Der Schliffwinkel des Steilschliffs liegt typischerweise zwischen 40 ° und 60 °, der Schliffwinkel des Flachschliffs typischerweise zwischen 3 ° und 5 °. Die weiteren Arbeitsschritte, nämlich Ätzen des Randes in einem Gemisch aus Salpetersäure, Flußsäure und Essigsäure. Abdecken des Randes mit Silikonkautschuk, Anbringen von Druckkontakt-Stromzuführungen und Kapselung in einem hermetisch verschlossenen Gehäuse, unterscheiden sich nicht von den in der Thyristortechnologie üblichen Verfahren.

Erläuternde Angaben zu Figur 9:

Konzentrationsprofile im $n^+pn^-np^+$-ASCR
Stärke der Siliziumscheibe: 330 µm
Stärke des $n^+$-Emitters 4: 15 bis 30 µm, typisch 20 µm
Stärke der Steuerbasiszone 3: 50 bis 70 µm, typisch 60 µm
Stärke des schwach n-dotierten Bereichs 2 a: 140 bis 170 µm, typisch 160 µm
Stärke der n-dotierten Zone 2 b: 55 bis 75 µm, typisch 60 µm
Stärke der $p^+$-dotierten Emitterzone 1: 25 bis 35 µm, typisch 30 µm
Maximale Netto-Akzeptorkonzentration in der Steuerbasiszone 3: $N_{Amax} = 9 \cdot 10^{16}$ bis $3 \cdot 10^{17}$ Atome/$cm^3$
Maximale Netto-Donatorkonzentration in der Zone 2 b: $N_{Dmax} = 4 \cdot 10^{15}$ bis $1 \cdot 10^{16}$ Atome/$cm^3$

Die praktische Ausführung mit Siliziumscheiben mit einem Durchmesser von 60 mm führt bei 2 000 V Sperrvermögen mit einer Trägerscheibe von 56 mm Durchmesser zu einem Hochleistungsthyristor, wie er für Antriebe, beispielsweise in der Traktion, benötigt wird.

Beispiel 2:

Herstellung eines asymmetrischen Thyristors (ASCR) mit einer $n^+pn^-np^+$-Zonenfolge, wobei die n-leitende Zone 2 b" durch Ionenimplantation von Phosphoratomen erzeugt wird.

Als Ausgangsmaterial werden zonengezogene, durch eine Phosphordotierung schwach n-leitende Siliziumkristalle von beispielsweise 76,2 mm Durchmesser benutzt, wobei die Phosphordotierung durch eine Neutronenbestrahlung erzeugt wird. Bei dem hier ausgeführten Beispiel eines asymmetrischen Thyristors mit einer maximalen Blockierspannung $u_{DRM} = 1\ 300$ V wird der spezifische Widerstand des Ausgangskristalls zu $\rho = 60\ \Omega cm \pm 20\ \%$ gewählt.

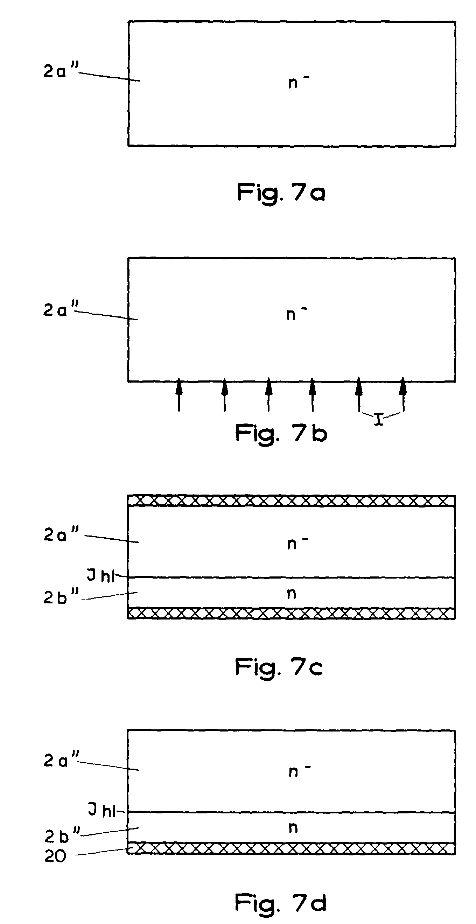

Durch Sägen und Läppen wird der Ausgangskristall zu Siliziumscheiben 2 a" von 250 ± 5 µm Stärke verarbeitet (siehe Figur 7 a). Eine Oberfläche der Siliziumscheiben, die spätere Anodenseite des Thyristors, wird gemäß Figur 7 b durch Ionenimplantation bei einer Beschleunigungsspannung von etwa 150 kV mit etwa 3 ·

$10^{15}$ Phosphoratomen/$cm^3$ belegt. Die Ionenimplantation ist als reproduzierbares homogenes Verfahren zur Einstellung der Dotierungskonzentration der Zone 2 b" besonders gut geeignet.

Durch einen ersten Oxidationsschritt - beispielsweise während einer Dauer von 7 h bei 1 150 °C in strömendem feuchtem Sauerstoff - und nachfolgender Eindiffusion während einer Dauer von 80 h bei 1 255 °C erhält man, wie die Figur 7 c zeigt, eine Siliziumscheibe, die aus einer $n^-$-leitenden Zone 2 a' ' und einer n-leitenden Zone 2 b' ' besteht. Der $nn^-$-Übergang $J_{h1}$ sollte in einer Tiefe v n etwa 60 µm, gemessen von der Oberfläche der n-leitenden Zone 2 b' ', liegen. Der Schichtwiderstand der n-leitenden Zone 2 b' ', gemessen an einer entoxidierten Testscheibe, sollte ungefähr $R_s = 8\ \Omega/\square$ betragen.

Im nächsten Arbeitsschritt werden die Siliziumscheiben einseitig, und zwar auf der Oberfläche der $n^-$-Zone 2 a' ', entoxidiert. Dieser Zustand der Siliziumscheibe (siehe Figur 7 d) entspricht weitgehend dem Zustand gemäß Figur 6 c, wie im ersten Beispiel bereits näher erläutert wurde. Allerdings besteht der Unterschied, daß die Phosphordotierung der n-Zone 2 b' in Figur 6 c ein Kastenprofil aufweist, die Phosphordotierung der n-Zone 2 b' ' in Figur 7 d ein Diffusionsprofil, das heißt ein Gauß-Profil besitzt.

Die weiteren Arbeitsschritte, Galliumdiffusion, Oxidmaskierung, Phosphordiffusion, erneute Oxidmaskierung und Bordiffusion, unterscheiden sich nicht vom ersten Ausführungsbeispiel (siehe Figuren 6 d bis 6 g). Bei der Prozeßführung werden die in Figur 9 angegebenen Störstellenprofile der $n^+$-Emitterzone 4, der Steuerbasiszone 3, der n-dotierten Zone 2 b und der $p^+$-dotierten Emitterzone 1 ebenfalls eingestellt. Die Stärke des schwach dotierten Bereichs 2 a beläuft sich - entsprechend dem geringen Sperrvermögen - auf etwa 90 µm.

Die typische Temperatur zur Eintemperung des Goldes liegt bei diesem nur 1 300 V sperrenden Bauelement ungefähr bei 850 bis 860 °C, entsprechend einer angestrebten Freiwerdezeit zwischen 8 und 15 µs.

Bei diesem kleineren Thyristor schließt sich hiernach ein geeigneter Zerteilungsprozeß an: Herausschneiden der kleinen runden Thyristorscheiben aus dem Siliziumwafer von 76,2 mm Durchmesser mittels Lasertrenn- oder Ultraschallbohren, die Herstellung der metallischen Gate- und Kathodenanschlüsse und der Legierungsprozeß mit einer Molybdän-Trägerscheibe. Die Randbearbeitung, die Passivierung und die Kapselung werden, wie bereits in Beispiel 1 erläutert wurde, ausgeführt.

Beispiel 3:

Herstellung eines asymmetrischen Thyristors (ASCR) mit einer $n^+pn^-np^+$-Zonenfolge, wobei die n-leitende Zone 2 b' ' ' durch Phosphorbelegung mittels planarer Feststoffquellen erzeugt wird.

Als Ausgangsmaterial werden zonengezogene, durch eine Phosphordotierung schwach n-leitende Siliziumkristalle von beispielsweise 60 mm Durchmesser benutzt, wobei die Phosphordotierung durch Neutronenbestrahlung erzeugt wurde. Bei dem hier ausgeführten Beispiel eines asymmetrischen Thyristors mit einer maximalen Blockierspannung $u_{DRM} = 1\,300$ V wird der spezifische Widerstand des Ausgangskristalls zu $\rho = 60$ $\Omega$cm $\pm$ 20 % gewählt.

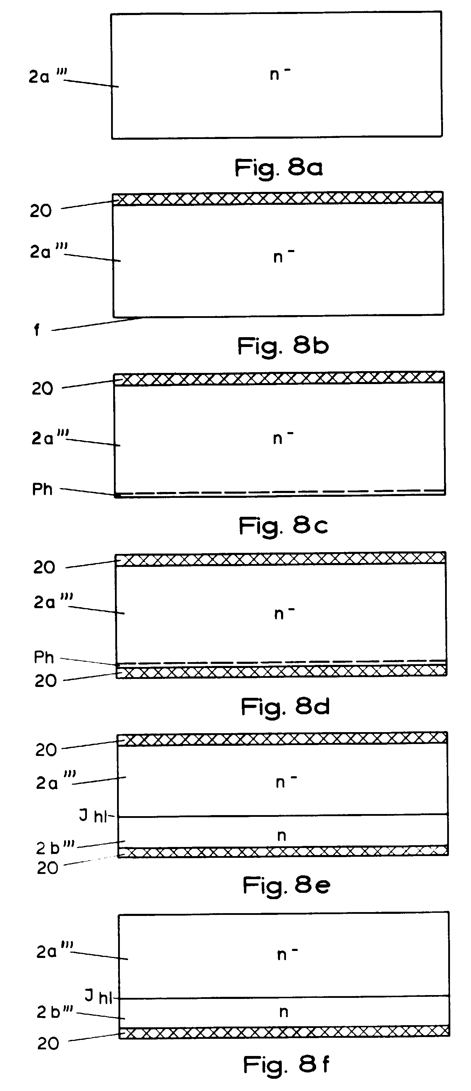

Durch Sägen und Läppen wird der Kristall zu Siliziumscheiben 2 a''' von 250 $\pm$ 5 $\mu$m Stärke verarbeitet, wie die Figur 8 a zeigt. Die gereinigten Siliziumscheiben werden in einem ersten Oxidationsschritt - beispielsweise während einer Dauer von 7 h bei 1 150 °C in strömenden feuchten Sauerstoff - mit einer Oxidschicht versehen. Eine Seite der Siliziumscheibe wird vollständig entoxidiert (siehe Figur 8 b). Die freigelegte Seite wird im nachfolgenden Belegungsprozeß mit Phosphor dotiert. Da die erforderliche Oberflächenkonzentration dieser Phosphordotierung um mehr als 2 Zehnerpotenzen unterhalb der Löslichkeitsgrenze liegt, wird vorteilhafterweise keine der üblichen flüssigen Dotierstoffquellen benutzt, wie etwa $POCl_3$ oder $PBr_3$. Die Reproduzierbarkeit und die Homogenität der Belegung mit diesen Quellen sind für die Herstellung der n-leitenden Zone 2 b''' des Thyristors unbefriedigend.

Das Verfahren der hier eingesetzten Phosphorbelegung besteht darin, daß Siliziumscheiben und Siliziumpyrophosphat-haltige Quellscheiben ($SiP_2O_7$) alternierend in Quarzhorden gestapelt werden, wobei der Abstand zwischen einer Quellscheibe und einer Siliziumscheibe etwa 1,5 mm beträgt. Bringt man diese Anordnung in einen üblichen mit einem Quarzrohr versehenen Diffusionsofen auf Temperaturen zwischen 850 und 1 000 °C in einem schwachen Stickstoffstrom, so dampft $P_2O_5$ von den Quellscheiben auf die Siliziumwafer über und führt zu einer homogenen, über Temperatur und Zeitdauer kontrollierbaren Phosphordotierung.

Im vorliegenden Beispiel werden die Siliziumscheiben während eine Dauer von 1 h bei 850 °C mit Phosphor belegt (siehe Figur 8 c). Die Siliziumscheiben werden dann aus der Horde genommen und in einem zweiten Oxidationsschritt während einer Dauer von 7 h bei 1 150 °C in feuchtem strömenden Sauerstoff vollständig oxidiert (siehe Figur 8 d). Nachfolgend wird die Phosphordotierung bei einer Temperatur von 1 255 °C während einer Dauer von 60 bis 80 h eindiffundiert. Nach diesem Hochtemperaturschritt, dessen Zustand die Figur 8 e zeigt, liegt die Eindringtiefe der n-leitenden Zone 2 b''' bei ungefähr 60 $\mu$m, gemessen von der Oberfläche der n-leitenden Zone 2 b'''. Der Schichtwiderstand der n-leitenden Zone 2 b''', gemessen an einer entoxidierten Testscheibe, sollte ungefähr $R_s = 8$ $\Omega/\square$ betragen.

Im nächsten Arbeitsschritt werden die Siliziumscheiben einseitig, und zwar auf der Oberfläche der n⁻-Zone 2 a''', entoxidiert. Der Zustand der Scheibe, den Figur 8 f zeigt, entspricht jetzt weitgehend dem Zustand gemäß Figur 6 c bzw. Figur 7 d. Weitere Arbeitsschritte, wie die Galliumdiffusion, die Oxidmaskierung, die Phosphordiffusion des n⁺-Emitters, die weitere Oxidmaskierung und die Bordiffusion, stimmen mit den Arbeitsschritten des Beispiels 2 überein.

## Patentansprüche

1. Asymmetrischer Thyristor aus einem scheibenförmigen Halbleiterkörper mit mindestens vier Zonen abwechselnd entgegengesetzten Leitungstyps, bei dem die beiden äußeren Zonen hoch n- bzw. hoch p-dotiert sind und die n-leitende Basiszone aus einer an die innere p-Schicht angrenzenden schwach dotierten n⁻-Schicht und einer an die äußere P⁺-Schicht angrenzenden höher dotierten n-Schicht mit vom nn⁻-Übergang ansteigender Dotierungskonzentration besteht,
   **dadurch gekennzeichnet**, daß die Dicke und die Dotierungskonzentration der n⁻-Schicht (2a) so bemessen sind, daß der Maximalwert der Feldstärke $E_2$ bei der höchsten Vorwärtsspannung am pn⁻-Übergang ($J_2$) 1,5 x $10^5$ V/cm beträgt, daß die Feldstärke in der n⁻-schicht (2a) entsprechend dem Verlauf ihrer Dotierung abnimmt und am nn⁻-Übergang ($J_{h1}$) einen Wert $E_{h1}$ von 0,1 $E_2$ bis 0,4 $E_2$ hat, und daß die Dotierungskonzentration in der n-Schicht (2b) von nn⁻-Übergang ($J_{h1}$) in Richtung zum anodenseitigen pn-Übergang ($J_1$) auf einer Strecke von mindestens 50 $\mu$m auf ihren Maximalwert ansteigt.

2. Asymmetrischer Thyristor nach Anspruch 1, **dadurch gekennzeichnet**, daß der Wert $E_{h1}$ zwischen 0,2 $E_2$ und 0,3 $E_2$ liegt.

3. Asymmetrischer Thyristor nach Anspruch 1 oder 2, dadurch gekennzeichnet, daß der anodenseitige pn-Übergang ($J_1$) mindestens 25 $\mu$m von der anodenseitigen Oberfläche des Halbleiterkörpers entfernt ist.

4. Verfahren zum Herstellen eines asymmetrischen Thyristors nach einem der Ansprüche 1 bis 3, gekennzeichnet durch die Reihenfolge nachstehend aufgeführter Verfahrensschritte

   a) Ausbilden einer n-leitenden Schicht (2 b') mit einer Schichtdicke von 45 bis 55 $\mu$m und einer Dotierungskonzentration von etwa 1,3 $\cdot$ $10^{17}$ Phosphoratomen/$cm^3$ durch epitaktisches Abscheiden auf ein schwach n-leitendes Siliziumsubstrat (2 a'),
   b) Aufbringen von Oxidschichten (20) auf die Oberflächen durch thermische Oxidation mit feuchtem Sauerstoff und anschließend einseitigem Abätzen der Oxidschicht auf der Oberfläche des schwach n-leitenden Substrats,

c) Eindiffusion von Gallium zur Bildung einer p-leitenden Zone (3') auf der nicht maskierten Oberfläche mit einer Eindringtiefe von etwa 60 µm und einer Galliumoberflächenkonzentration von 1 · 10^18 bis 6 · 10^18 Atomen/cm^3 und zur Bildung einer p-leitenden Zone (1') auf der maskierten Oberflächenseite und Ausbildung eines pn-Überganges (J_1) in einer Tiefe von 25 bis 35 µm,

d) Aufbringen einer Oxidschicht (21) durch thermische Oxidation mit feuchtem Sauerstoff auf der nicht mit einer Oxidschicht bedeckten Oberfläche der p-leitenden Zone (3'), Einätzen von Fenstern (22) in diese Oxidschicht und Eindiffusion von Phosphor durch diese Fenster bei etwa 1260 °C während einer Dauer von 4 bis 8 h mit einer Oberflächenkonzentration von etwa 5 · 10^21 Atomen/cm^3,

e) Schließen der geätzten Fenster (22) durch einen weiteren Oxidationsschritt mit feuchtem Sauerstoff, anschließendes Entfernen der anodenseitigen Oxidschicht (20) und Eindiffusion von Bor bei 1255 °C während einer Dauer von 1 bis 3 h und Ausbilden der p^+-Emitterschicht (1') mit einer Akzeptoroberflächenkonzentration von etwa 10^20 Atomen/cm^3,

f) Entfernen der kathodenseitigen Oxidschicht und Eindiffusion von Gold bei 830 bis 860 °C während einer Dauer von etwa 1 h nach Goldbedampfung der Siliziumscheiben im Hochvakuum oder chemischer Goldabscheidung aus einer Goldsalzlösung.

5. Verfahren zum Herstellen eines asymmetrischen Thyristors nach einem der Ansprüche 1 bis 3, gekennzeichnet durch die Reihenfolge nachstehend aufgeführter Verfahrensschritte

a) Ausbilden einer n-leitenden Schicht (2 b") durch Ionenimplantation von etwa 3 · 10^15 Phosphoratomen/cm^2 auf einem schwach n-leitenden Siliziumsubstrat und nachfolgender Eindiffusion der Phosphoratome, so daß der entstehende nn^--Übergang in einer Tiefe von mindestens 60 µm von der belegten Oberfläche gebildet wird,

b) Aufbringen von Oxidschichten (20) auf die Oberflächen durch thermische Oxidation mit feuchtem Sauerstoff und anschließend einseitigem Abätzen der Oxidschicht auf der Oberfläche des schwach n-leitenden Substrats,

c) Eindiffusion von Gallium zur Bildung einer p-leitenden Zone (3') auf der nicht maskierten Oberfläche mit einer Eindringtiefe von etwa 60 µm und einer Galliumoberflächenkonzentration von 1 · 10^18 bis 6 · 10^18 Atomen/cm^3 und zur Bildung einer p-leitenden Zone (1') auf der maskierten Oberflächenseite und Ausbildung eines pn-Überganges (J_1) in einer Tiefe von 25 bis 35 µm,

d) Aufbringen einer Oxidschicht (21) durch thermische Oxidation mit feuchtem Sauerstoff auf der nicht mit einer Oxidschicht bedeckten Oberfläche der p-leitenden Zone (3'), Einätzen von Fenstern (22) in diese Oxidschicht und Eindiffusion von Phosphor durch diese Fenster bei etwa 1260 °C während einer Dauer von 4 bis 8 h mit einer Oberflächenkonzentration von etwa 5 · 10^21 Atomen/cm^3,

e) Schließen der geätzten Fenster (22) durch einen weiteren Oxidationsschritt mit feuchtem Sauerstoff, anschließendes Entfernen der anodenseitigen Oxidschicht (20) und Eindiffusion von Bor bei 1255 °C während einer Dauer von 1 bis 3 h und Ausbilden der p^+-Emitterschicht (1') mit einer Akzeptorkonzentration von etwa 10^20 Atomen/cm^3,

f) Entfernen der kathodenseitigen Oxidschicht und Eindiffusion von Gold bei 830 bis 860 °C während einer Dauer von etwa 1 h nach Goldbedampfung der Siliziumscheiben im Hochvakuum oder chemischer Goldabscheidung aus einer Goldsalzlösung.

## Claims

1. Asymmetrical thyristor comprising a semiconductor body in the form of a wafer and having at least four zones of alternately opposing conduction type, in which the two outer zones are heavily n- and heavily p-doped and the n-conducting base zone is composed of a weakly doped n^--type layer adjoining the inner p-type layer and of a more heavily doped n-type layer adjoining the outer p^+-type layer, with a doping concentration which increases from the nn^- junction, characterized in that the thickness and the doping concentration of the n^--type layer (2a) are dimensioned in such a way that the maximum value of the field strength $E_2$ at the highest forward voltage at the pn^- junction ($J_2$) is 1.5 x 10^5 V/cm, in that the field strength in the n^--type layer (2a) decreases in accordance with its doping profile and has a value $E_{h1}$ of 0.1 $E_2$ to 0.4 $E_2$ at the nn^- junction ($J_{h1}$), and in that that the doping concentration in the n-type layer (2b) increases to its maximum value, from the nn^- junction ($J_{h1}$) in the direction of the anode-side pn junction ($J_1$), over a distance of at least 50 µm.

2. Asymmetrical thyristor according to Claim 1, characterized in that the value $E_{h1}$ lies between 0.2 $E_2$ and 0.3 $E_2$.

3. Asymmetrical thyristor according to Claim 1 or 2, characterized in that the anode-side pn junction ($J_1$)

is at least 25 µm away from the anode-side surface of the semiconductor body.

**4.** Method for the production of an asymmetrical thyristor according to one of Claims 1 to 3, characterized by the sequence of method steps cited below

a) formation of an n-conducting layer (2 b') with a layer thickness of 45 to 55 µm and a doping concentration of approximately $1.3 \cdot 10^{17}$ phosphorus atoms/cm$^3$ by means of epitaxial deposition up to a weakly n-conducting silicon substrate (2 a'),

b) application of oxide layers (20) to the surfaces by means of thermal oxidation with moist oxygen and then single-sided etching away of the oxide layer on the surface of the weakly n-conducting substrate,

c) indiffusion of gallium in order to form a p-conducting zone (3') on the unmasked surface with a penetration depth of approximately 60 µm and a gallium surface concentration of $1 \cdot 10^{18}$ to $6 \cdot 10^{18}$ atoms/cm$^3$ and in order to form a p-conducting zone (1') on the masked surface side and a pn junction ($J_1$) at a depth of 25 to 35 µm,

d) application of an oxide layer (21) by means of thermal oxidation with moist oxygen to that surface of the p-conducting zone (3') which is not covered by an oxide layer, etching windows (22) into this oxide layer and indiffusion of phosphorus through these windows at approximately 1260°C for a duration of 4 to 8 h at a surface concentration of approximately $5 \cdot 10^{21}$ atoms/cm$^3$,

e) closing the etched windows (22) by means of a further oxidation step with moist oxygen, subsequent removal of the anode-side oxide layer (20) and indiffusion of boron at 1255°C for a duration of 1 to 3 h and formation of the p$^+$-type emitter layer (1') with an acceptor surface concentration of approximately $10^{20}$ atoms/cm$^3$,

f) removal of the cathode-side oxide layer and indiffusion of gold at 830 to 860°C for a duration of approximately 1 h after vapour deposition of gold onto the silicon wafers in a high vacuum or chemical deposition of gold from a gold salt solution.

**5.** Method for the production of an asymmetrical thyristor according to one of Claims 1 to 3, characterized by the sequence of method steps cited below

a) formation of an n-conducting layer (2 b'') by means of ion implantation of approximately $3 \cdot 10^{15}$ phosphorus atoms/cm$^2$ on a weakly n-conducting silicon substrate and subsequent indiffusion of the phosphorus atoms, so that the resulting nn$^-$ junction is formed at a depth of at least 60 µm from the surface onto which deposition took place,

b) application of oxide layers (20) to the surfaces by means of thermal oxidation with moist oxygen and then single-sided etching away of the oxide layer on the surface of the weakly n-conducting substrate,

c) indiffusion of gallium in order to form a p-conducting zone (3') on the unmasked surface with a penetration depth of approximately 60 µm and a gallium surface concentration of $1 \cdot 10^{18}$ to $6 \cdot 10^{18}$ atoms/cm$^3$ and in order to form a p-conducting zone (1') on the masked surface side and a pn junction ($J_1$) at a depth of 25 to 35 µm,

d) application of an oxide layer (21) by means of thermal oxidation with moist oxygen to that surface of the p-conducting zone (3') which is not covered by an oxide layer, etching windows (22) into this oxide layer and indiffusion of phosphorus through these windows at approximately 1260°C for a duration of 4 to 8 h at a surface concentration of approximately $5 \cdot 10^{21}$ atoms/cm$^3$,

e) closing the etched windows (22) by means of a further oxidation step with moist oxygen, subsequent removal of the anode-side oxide layer (20) and indiffusion of boron at 1255°C for a duration of 1 to 3 h and formation of the p$^+$-type emitter layer (1') with an acceptor concentration of approximately $10^{20}$ atoms/cm$^3$,

f) removal of the cathode-side oxide layer and indiffusion of gold at 830 to 860°C for a duration of approximately 1 h after vapour deposition of gold onto the silicon wafers in a high vacuum or chemical deposition of gold from a gold salt solution.

## Revendications

**1.** Thyristor dissymétrique constitué d'un élément en semiconducteur en forme de pastille qui comporte au moins quatre zones de type de conductivité alternativement opposé, dans lequel les deux zones extérieures sont fortement dopées en ayant respectivement une conductivité de type n et une conductivité de type p et dans lequel la zone de base de type de conductivité n est constituée d'une couche faiblement dopée de type de conductivité n-, adjacente à la couche intérieure de type de conductivité p, et d'une couche plus fortement dopée de type de conductivité n, adjacente à la couche de type de conductivité p$^+$ extérieure et ayant une concentration en substance dopante croissante à partir de la transition nn-, caractérisé en ce que l'épaisseur et la concentration en substance dopante de la couche (2a) de type de conductivité n- sont prévues de manière que la valeur maximum de l'intensité $E_2$ de champ soit, pour la tension directe la plus grande à la transition ($J_2$) pn-, de 1,5 x 10⁵ V/cm, que l'intensité de champ diminue dans la couche (2a) de type de conductivité n- en fonction de l'allure de son dopage et ait à la transition ($J_{h1}$) nn- une valeur $E_{h1}$ de 0,1 $E_2$ à 0,4 $E_2$, et que la concentration en substance dopante de la couche (2b) de type de conductivité n augmente de la transition ($J_{h1}$) nn-, sur une distance d'au moins 50 μm, en direction de la transition ($J_1$) pn située du côté de l'anode, à sa valeur maximum.

2. Thyristor dissymétrique suivant la revendication 1, caractérisé en ce que la valeur $E_{h1}$ est comprise entre 0,2 $E_2$ et 0,3 $E_2$.

3. Thyristor dissymétrique suivant la revendication 1 ou 2, caractérisé en ce que la transition ($J_1$) pn située du côté de l'anode est distante d'au moins 25 μm de la surface de l'élément en semiconducteur situé du côté de l'anode.

4. Procédé de fabrication d'un thyristor dissymétrique suivant l'une des revendications 1 à 3, caractérisé par la succession qui suit d'étapes opératoires exposées

a) on forme une couche (2b') de type de conductivité n, ayant une épaisseur de couche comprise entre 45 et 55 μm et une concentration de dopage d'environ 1,3 . 10¹⁷ atomes de phosphore/cm³, par dépôt épitaxial sur un substrat (2a') en silicium à faible dopage de type de conductivité n,

b) on dépose des couches (20) d'oxyde sur les surfaces par oxydation thermique par de l'oxygène humide et on enlève ensuite par attaque chimique d'un seul côté la couche d'oxyde à la surface du substrat à faible dopage de type de conductivité n,

c) on diffuse du gallium pour former une zone (3') de type de conductivité p sur la surface non masquée, ayant une profondeur de pénétration d'environ 60 μm et une concentration superficielle en gallium de 1 . 10¹⁸ à 6 . 10¹⁸ atomes/ cm³, et pour former une zone (1') de type de conductivité p sur la surface masquée et on forme une transition ($J_1$) pn à une profondeur de 25 à 35 μm,

d) on dépose une couche (21) d'oxyde par oxydation thermique par de l'oxygène humide sur la surface de la zone (3') de type de conductivité p qui n'est pas revêtue d'une couche d'oxyde, on ménage par attaque chimique des fenêtres (22) dans cette couche d'oxyde et on diffuse du phosphore par ces fenêtres à une température de 1260° C environ, pendant une durée de 4 à 8 h, en ayant une concentration superficielle d'environ 5 . 10²¹ atomes/cm³,

e) on ferme les fenêtres (22) ménagées par attaque chimique par une autre étape d'oxydation par de l'oxygène humide, on enlève ensuite la couche (20) d'oxyde située du côté anodique et on diffuse du bore à 1255° C, pendant une durée de 1 à 3 h et on forme la couche (1') d'émetteur de type de conductivité p+ par une concentration superficielle d'accepteurs d'environ 10²⁰ atomes/cm³,

f) on enlève la couche d'oxyde située du côté cathodique et on diffuse de l'or à une température comprise entre 830 et 860° C, pendant une durée d'environ 1h, par métallisation à l'or des pastilles de silicium sous vide très poussé ou par dépôt chimique d'or provenant d'une solution d'aurate.

5. Procédé de fabrication d'un thyristor dissymétrique suivant l'une des revendications 1 à 3, caractérisé par la succession qui suit d'étapes opératoires exposées

a) on forme une couche (2b'') de type de conductivité n, par implantation ionique d'environ 3 . 10¹⁵ atomes de phosphore/cm², sur un substrat en silicium à faible dopage de type de conductivité n et ensuite on diffuse les atomes de phosphore de manière que la transition nn- produite soit formée à une profondeur d'au moins 60 μm de la surface revêtue,

b) on dépose des couches (20) d'oxyde sur les surfaces par oxydation thermique par de l'oxygène humide et on enlève ensuite par attaque chimique d'un seul côté la couche d'oxyde à la surface du substrat à faible dopage de type de conductivité n,

c) on diffuse du gallium pour former une zone (3') de type de conductivité p sur la surface non masquée, ayant une profondeur de pénétration d'environ 60 μm et une concentration superficielle en gallium de 1 . 10¹⁸ à 6 . 10¹⁸ atomes/ cm³, et pour former une zone (1') de type de conductivité p sur la surface masquée et une transition pn ($J_1$) à une profondeur de 25 à 35 μm,

d) on dépose une couche (21) d'oxyde par oxydation thermique par de l'oxygène humide sur la surface de la zone (3') de type de conductivité p qui n'est pas revêtue d'une couche d'oxyde, on ménage par attaque chimique des fenêtres (22) dans cette couche d'oxyde et on diffuse du phosphore par ces fenêtres à une température de 1260° C environ, pendant une durée de 4 à 8 h, en ayant une concentration su-

perficielle d'environ 5 . $10^{21}$ atomes/cm$^3$,

e) on ferme les fenêtres (22) ménagées par attaque chimique par une autre étape d'oxydation par de l'oxygène humide, on enlève ensuite la couche (20) d'oxyde située du côté anodique et on diffuse du bore à 1255° C, pendant une durée de 1 à 3 h et on forme la couche (1') d'émetteur de type de conductivité p$^+$ par une concentration superficielle d'accepteurs d'environ $10^{20}$ atomes/cm$^3$,

f) on enlève la couche d'oxyde située du côté cathodique et on diffuse de l'or à une température comprise entre 830 et 860° C, pendant une durée d'environ 1h, par métallisation à l'or des pastilles de silicium sous vide très poussé ou par dépôt chimique d'or provenant d'une solution d'aurate.

Fig. 1

Fig. 2

Fig. 3

Fig. 4

Fig. 5

2a' ——— n⁻

## Fig. 6a

2a' ——— n⁻

2b' ——— n

## Fig. 6b

2a' ——— n⁻

2b' ——— n

20 ———

## Fig. 6c

3' ——— p

J₂

2a' ——— n⁻

2b' J hl

n

1' J₁

p

20 ———

## Fig. 6d

21  22  J 3

4' ———

3' ———  J₂

n⁺      p      n⁺

2a' ———  n⁻

2b' J hl

n

1' J₁

p

20 ———

## Fig. 6e

21
4'
3'  J2
2a'
Jhl
2b'
J1
1'

p

n⁻

n

p

**Fig. 6 f**

3'
J2
2a'
Jhl
2b'
J1
1'

p

n⁻

n

p⁺

**Fig. 6 g**

7
9
4'
3'  J2
2a'
Jhl
2b'
J1
1'
11
5

p

n⁻

n

p⁺

**Fig. 6 h**

7
4'
3'
2a'
2b'
1'
11
5

n⁺

p

n⁻

n

p⁺

S1

S2

**Fig. 6 i**

$2a''$ — | $n^-$ |

**Fig. 7a**

$2a''$ — | $n^-$ |

↑ ↑ ↑ ↑ ↑ ↑ I

**Fig. 7b**

$2a''$ — | $n^-$ |
J hl —
$2b''$ — | n |

**Fig. 7c**

$2a''$ — | $n^-$ |
J hl —
$2b''$ —
20 — | n |

**Fig. 7d**

18

2a'''

**Fig. 8a**

20

2a'''

f

**Fig. 8b**

20

2a'''

Ph

**Fig. 8c**

20

2a'''

Ph

20

**Fig. 8d**

20

2a'''

J hl

2 b'''

20

**Fig. 8e**

2a'''

J hl

2 b'''

20

**Fig. 8 f**

Fig. 9